Europäisches Patentamt

European Patent Office

Office européen des brevets

(19)

(11) Publication number: **0 021 762**
**B1**

(12) **EUROPEAN PATENT SPECIFICATION**

(45) Date of publication of patent specification: **07.03.84**

(21) Application number: **80302020.5**

(22) Date of filing: **16.06.80**

(51) Int. Cl.³: **H 04 B 1/18, H 01 Q 23/00,**
**H 03 J 3/24, H 03 J 9/06**

(54) Electronic tuning antenna system.

(30) Priority: **14.06.79 JP 76245/79**
**14.06.79 JP 76246/79**
**14.06.79 JP 76249/79**
**14.06.79 JP 76251/79**

(43) Date of publication of application:
**07.01.81 Bulletin 81/1**

(45) Publication of the grant of the patent:
**07.03.84 Bulletin 84/10**

(84) Designated Contracting States:
**DE FR GB**

(56) References cited:
**DE - A - 1 766 720**
**DE - A - 2 456 206**
**DE - A - 2 606 271**
**DE - A - 2 816 786**
**DE - A - 2 821 202**
**DE - A - 2 826 474**
**DE - B - 1 616 278**
**DE - B - 2 023 906**
**US - A - 4 021 810**
**US - A - 4 038 662**

(73) Proprietor: **Matsushita Electric Industrial Co., Ltd.**
**1006, Oaza Kadoma**
**Kadoma-shi Osaka-fu, 571 (JP)**

(72) Inventor: **Kane, Johji**
**930, Kanaoka-cho Sakai-shi**
**Osaka-fu (JP)**

(74) Representative: **Crawford, Andrew Birkby et al,**
**A.A. THORNTON & CO. Northumberland House**
**303-306 High Holborn**
**London WC1V 7LE (GB)**

Courier Press, Leamington Spa, England.

## Electronic tuning antenna system

The present invention relates to an electronic tuning antenna system which may be used for receiving television signals in the VHF and UHF bands, FM radio signals, or any other communications signals.

At present, a widely used and efficient antenna element is a dipole antenna having a length equal to half of the wave length of the signal being received or transmitted. However, a half-wave length dipole antenna for a frequency band in the VHF band is very large in size from the viewpoint of practical use.

Such a large-sized antenna is difficult to set and has many problems of maintenance and safety. Therefore, from the viewpoint of facilitating setting the antenna, it is desirable to make the antenna as small as possible.

Hitherto, it has been tried or proposed in other fields to make a small-sized dipole antenna, in which antenna gain has been very low in comparison with the half wave-length dipole antenna.

The reason for this is that a loading means is required to contract the dipole antenna in length, and this loading means causes a loss of radiation power as a result of the resistance loss which exists in a small-sized dipole antenna, thereby considerably reducing the radiation power and resulting in low radiation efficiency.

Lowering of the radiation efficiency, of course, means lowering of the antenna gain.

Furthermore, even with the aforesaid half-wave length dipole antenna, set values of V.S.W.R. at the feed terminals of the antenna cannot be ideal at all frequency points within the corresponding frequency band, which is due to the fact that the half-wave length dipole antenna of fixed length has only one perfect frequency resonance condition, the values of V.S.W.R. being of course deteriorated at other frequencies. The defect causes mismatching in characteristic impedance between the half-wave dipole antenna and any radio receiver connected thereto. A reflection loss exists in reception signal energy transmission due to the mismatching, thereby lowering the gain of the complete antenna system including the antenna and radio receiver.

From the above, it may be seen that a small-sized antenna is required which has a high gain and ideal values of V.S.W.R. in the characteristic impedance at the feed terminals at all frequency points within a corresponding frequency band.

There is known, from DE—A—2,456,206, an electronic tuning antenna system comprising an antenna which includes at least one antenna element having distributed constant inductance, at least one variable reactance circuit connected to the or each antenna element, the or each variable reactance circuit including a variable capacity diode, and means for applying a controllable bias voltage to the or each variable capacity diode in response to a control signal provided by a communications apparatus connectable to the antenna system so as to allow passage therebetween of electrical signals associated with conversion between electromagnetic radiation and electrical signals at the antenna, whereby said control signal tunes the antenna system.

In this known system, the control signal is a D.C. signal passed along the co-axial cable between communications apparatus (receiver) and antenna system, the same cable being used for the received signal. The D.C. signal acts directly as the control bias voltage for the variable capacity diode, and this acts to tune the antenna system. However, such an arrangement is subject to inaccurate matching between receiver and antenna, since any voltage drop along the length of the cable will affect the tuning of the antenna. Furthermore, antenna and receiver must be specifically designed for mutual compatability since any variation in the characteristics of the variable capacity diodes will require different voltage characteristics to be sent from the receiver, to ensure reasonably accurate tuning.

In accordance with the present invention, there is provided a system of the above-described type, characterised in that said means for applying a controllable bias voltage comprises a frequency discriminator whose output provides the controllable bias voltage, and in that said communications apparatus includes a phase-locked loop circuit generating an oscillating signal at a frequency related to a selected frequency of said electrical signals at the antenna, said oscillating signal being fed to said frequency discriminator to provide said controllable bias voltage.

Such an arrangement provides the advantage that the oscillating signal can very readily be obtained from a phase-locked loop circuit and can be used directly or to generate a suitable signal for transmission to the antenna system. The frequency discriminator in the antenna system will provide whatever voltage is required for the characteristics of the particular variable capacity diodes, and as long as a suitable standard is defined for the point of deviation of the oscillating signal within the phase-locked loop in the receiver, compatability between a variety of antenna systems and receivers will be assured.

The invention may be equally well applied to antenna systems for transmitting or receiving signals. In the former case, the communications apparatus will be a transmitter, and in the latter case, it will be a receiver. The embodiments described hereafter will, for the sake of convenience, be described with reference to a radio receiver.

Embodiments of the invention provide antenna systems which have antenna elements of reduced size, improve the gain of the antenna, control electronically the tuning of the antenna with the radio receiver connected thereto, and connect the antenna and radio receiver so that matching of the characteristic impedance therebetween is always ideal, thereby eliminating loss in the receiving signal energy transmission between the antenna and the receiver as much as possible, so as to obtain a high gain.

An embodiment of the antenna system of the invention is a receiving antenna system for receiving FM radio including a remote-set radio receiver. The antenna system preferably includes elements of turnback shape comprising continuous transmission conductor ways, and has at the feed side of the antenna elements, which have distributed constant inductance, the variable tuning unit including the voltage variable reactance and an impedance adjusting reactance element. The antenna feed terminals are connected with the input terminals of the remote-set radio receiver through a coaxial cable. The tuning control signal generated within the radio receiver is fed through the coaxial cable to tune the or each variable capacity diode within the voltage variable reactance circuit of the antenna circuit, the antenna circuit being resonant by means of the tuning control signal with the particular variable frequency previously set within the frequency band. The antenna elements having distributed constant inductance are combined with the variable tuning unit to function to have the best antenna radiation efficiency. For a signal at the resonant frequency, the characteristic impedance at the feed terminals to the antenna circuit is equal to that at the receiving input terminals of the radio receiver connected to the antenna circuit, so that a RF signal of selected resonance is fed to the radio receiver most effectively through the coaxial cable.

It is therefore possible to provide a relatively small antenna having high gain by use of the distributed constant loading elements combined with the tuning unit, and it is possible to provide an antenna system of high gain due to the fact that ideal matching of the characteristic impedances of the antenna and radio receiver is realized to enable a reduction in transmission loss of the received signal.

By using the oscillating signal from the phase-locked loop of the receiver as the control signal used for tuning both the antenna and radio receiver, the divided frequency signal being fed to the antenna through the coaxial cable and converted into the tuning control d.c. voltage through a frequency to d.c. voltage converter, it is possible to obtain closely matched tuning control in association.

In order that the present invention may be more readily understood, embodiments thereof will now be described, by way of example, with reference to the accompanying drawings, in which:

Figures 1(a) and 1(b) show schematically a conventional contraction type antenna;

Figure 2 shows an example of antenna element usable in the antenna system of the invention;

Figure 3 shows a construction of part of an embodiment of an antenna system according to the invention;

Figure 4 is a view of the characteristic curve of reactance to frequency of a parallel resonance circuit for tuning control of the system shown in Figure 3;

Figure 5 is a view of the characteristic curve of impedance of each antenna of the system shown in Figure 3;

Figure 6 shows one of the operating principles of the antenna system of the invention;

Figures 7 to 14 are views of various other examples of antenna element which can be used in the antenna system of the invention;

Figures 15 and 16 are views of other modifications to the arrangement of antenna elements;

Figure 17 shows an enlarged view of a further example of antenna element which is a modification of that shown in Figure 2;

Figures 18 to 21 are enlarged views of still further examples of antenna elements which are modifications of that shown in Figure 2;

Figure 22(a) is an enlarged view of the principal portion of an element which is a further modification of that shown in Figure 2;

Figure 22(b) is a sectional view of the principle portion shown in Figure 22(a);

Figures 23 to 25 show yet further examples of antenna elements in which (a) show developed views of each antenna element and (b) show sectional views thereof;

Figures 26 to 28 show yet further examples of antenna elements in which (a) is a perspective view thereof and (b) is a sectional view of the same;

Figure 29 is a circuit diagram of an embodiment of the invention;

Figure 30 is a circuit diagram of part of a modified embodiment of the invention;

Figure 31 is a circuit diagram of part of a further modified embodiment of the invention;

Figures 32 and 33 show two further arrangements of antenna elements;

Figure 34 is a block diagram of an embodiment of a receiving device;

Figure 35 is a circuit diagram of a particular construction of antenna system including switched reactances;

Figures 36 and 37 are illustrations of the operational principle of the system shown in Figure 35;

Figures 38(a) and 38(b) show two embodiments of phase difference feeding type antenna systems;

Figure 39 is a view of the directional characteristic curve of the antenna system shown in Figure 38(a);

Figure 40 is a view of the characteristic curve of the frequency-gain of the antenna system shown in Figure 38(a);

Figure 41 is a view showing a modified embodiment of the phase difference feeding type antenna system;

Figure 42 is a view directional characteristic curve of the antenna system shown in Figure 41;

Figure 43 is a view of the electric field directional characteristic curve of the antenna system shown in Figure 41; and

Figures 44 and 45 are views showing yet further modified embodiments.

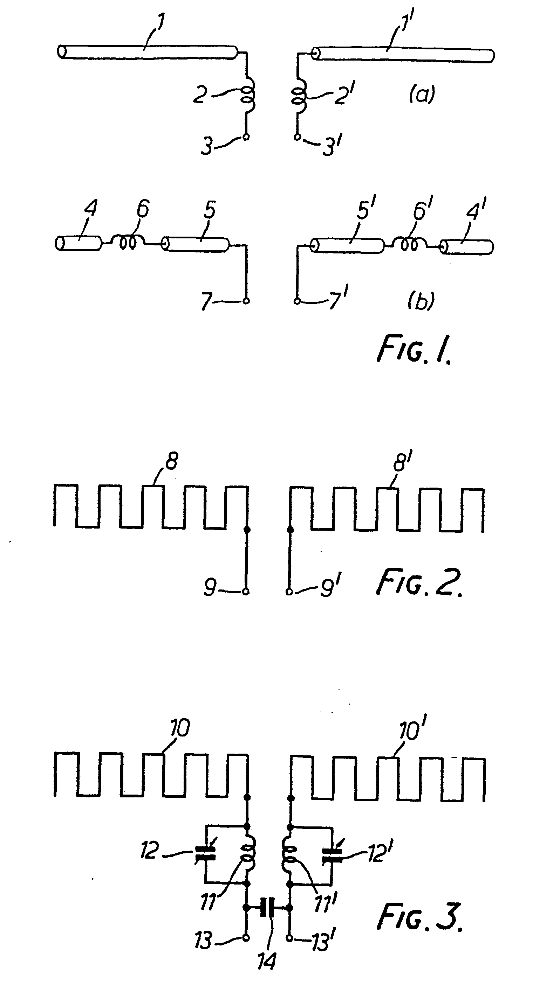

When an antenna is small-sized relative to the wave length of the signal in use, radiation resistance considerably decreases relative to radiation reactance. Hence, radiation efficiency lowers to reduce the working gain of the antenna. Therefore, it has previously been difficult to materialize a small-sized antenna, which does not lower the radiation efficiency and, even with an element length nearly as small as a conventional small-sized antenna, is high in working gain. Conventionally, a loading antenna has been proposed to put the small-sized antenna in practice. A conventional contraction type dipole antenna is exemplified in Figures 1(a) and 1(b).

In Figure 1(a), the dipole antenna has contracted elements 1, 1' in combination with coils 2, 2' having reactance components negativing the reactance components of the elements 1, 1' so that the impedance at the feed terminals 3, 3' becomes a desired value at the desired frequency. In Figure 1(b), coils 6 and 6' are added between contracted elements 4 and 5 and between elements 4' and 5' thereby negativing the reactance components of these elements so that the impedance at the feed terminals 7, 7' becomes a desired resistance value at the desired frequency. These antenna devices, however, require very large reactances to be added to the contracted elements, whereby the loss introduced by each coil lowers the radiation efficiency to reduce the working gain of the antenna, thereby not being practicable.

Referring to Figure 2, a typical construction of an antenna element which may be used in this invention is shown, in which contracted elements 8 and 8' (hereinafter referred to merely as elements 8, 8') having distributed constant inductance comprise metallic foil or wire, such as copper, aluminium or iron, of low electric resistance value, or conductive foil on a printed base, and are bent at desired points a desired number of times in each direction, and at each angle to thereby be formed as shown. The elements 8, 8' have distributed constant impedance caused by bending the conductors and by continuously arranging the conductors at the bending points and between each bending point so as to be distributed mutually lengthwise of and perpendicularly to each element, thereby being equivalent to the conventional elements, as shown in Figures 1(a) and (b), when provided with coils for negativing the reactance of each element. Hence, the use of such elements 8, 8' requires no concentrated constant coils used conventionally. Furthermore, since the conductors constituting the elements 8, 8' can be of material of foil-like or tube-like shape of wide surface area, losses can be significantly reduced. Hence, it is possible to solve the problem of the hitherto large losses caused by inclusion of separate coils which lower the radiation efficiency, thereby to improve the working gain and to realize an antenna sufficiently efficient even when small-sized.

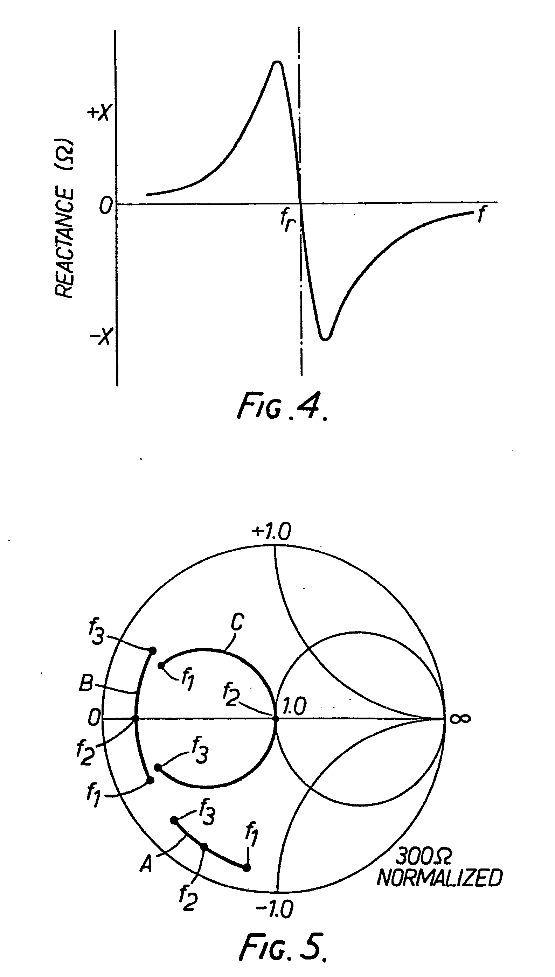

Figure 3 shows a part of an embodiment useful in understanding one of the operating principles of the invention. Since the antenna arrangement in Figure 2 can adopt tuning (matching) only over a rather limited range of frequencies, variable reactance circuits are interconnected with the element circuits. A parallel resonance or series resonance circuit is usable as the variable reactance circuit. For example, when using the parallel resonance circuit, its reactance, as shown in Figure 4, is respectively maximum positive and negative values before and after the resonance frequency $fr$, whereby $fr$ is properly set to enable control of reactance component of the element. An element pattern is so designed that the impedance at frequences $f_1$—$f_2$—$f_3$ of units 10, 10' of the elements in Figure 3, is adjusted by connecting to the elements parallel resonance circuits each comprising a coil 11 and variable capacitor 12, and a coil 11' and variable capacitor 12', the resonance frequency being set to a desired value so that the reactance becomes positive at the frequencies $f_1$—$f_2$—$f_3$, whereby the impedance follows a curve $B$ as shown in Figure 5. Furthermore, when a capacitor 14 is interposed between feed terminals 13 and 13', the impedance describes a curve $C$ in Figure 5, thus obtaining tuning at frequency $f_2$. It is enough to satisfy the tuning condition within the whole zone of frequencies $f_1$—$f_2$—$f_3$ by changing the values of the variable capacitors 12, 12', thus changing the resonance frequency, and changing the reactance component added to the elements 10, 10'.

The arrangement in Figure 3 employs a parallel resonance circuit. Alternatively, a series resonance circuit may be used to provide the required reactance value.

Figure 6 shows a circuit useful for understanding operation of the invention. Part of the circuit operates in similar manner to the aforementioned DE—A—2,456,206. Parallel resonance circuits each comprise a coil 16, variable capacity diode 17 and capacitor 18; and a coil 16', variable capacity diode 17' and capacitor 18'. These circuits are connected with respect to elements 15, 15' respectively so that the bias voltage for the variable capacity diodes 17, 17' is provided by the voltage variably divided by a potentiometer 20 from the voltage of a d.c. source 19 and supplied through high-frequency blocking resistances 21, 21'. If a capacitor 23 is provided between the feed terminals 22 and 22', tuning is obtainable in the same manner as in the arrangement of Figure 3 and remote tuning control is possible. In addition, in Figure 6, reference numerals 24, 24' designate high value resistances for feeding bias voltage to the variable capacity diodes 17, 17'.

As seen from the above, this arrangement makes it possible to constitute a tunable antenna which is small in comparison with the wave lengths being received and at an individual frequency with respect to the whole range of desired frequencies.

The antenna elements 15, 15' can be produced by etching a printed base or punching metallic foils, which makes them easy and inexpensive to manufacture. When using a printed base especially, patterns of elements and circuitry can be formed simultaneously on the same base, thereby enabling integral construction to be achieved, which is advantageous in reduction of the number of processes and provides improvement in reliability. Also, the antenna has narrow-band characteristics so as to rejet signals other than the desired signal, and also has good interference signal eliminating capability, thereby presenting good receiving performance with respect to a connected receiver.

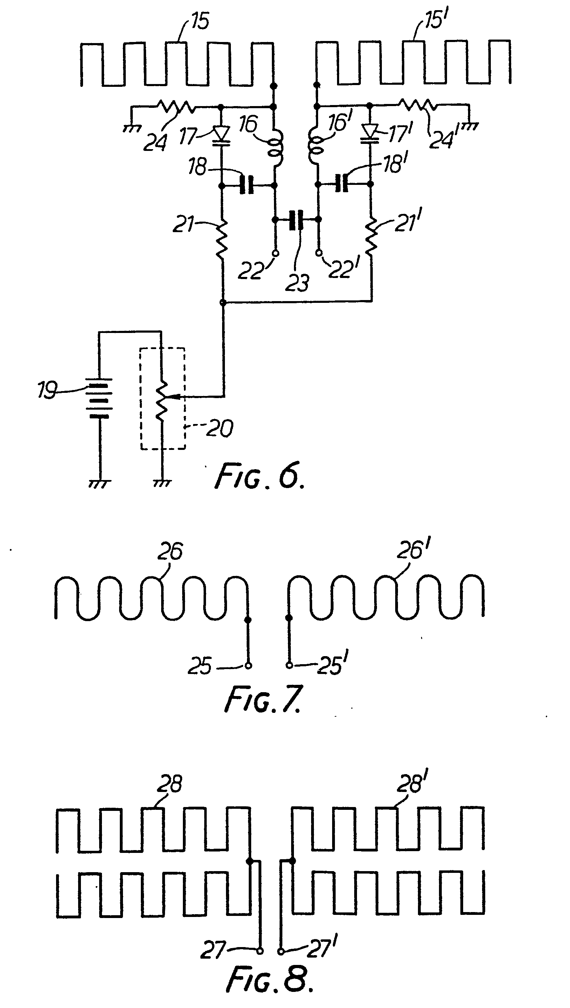

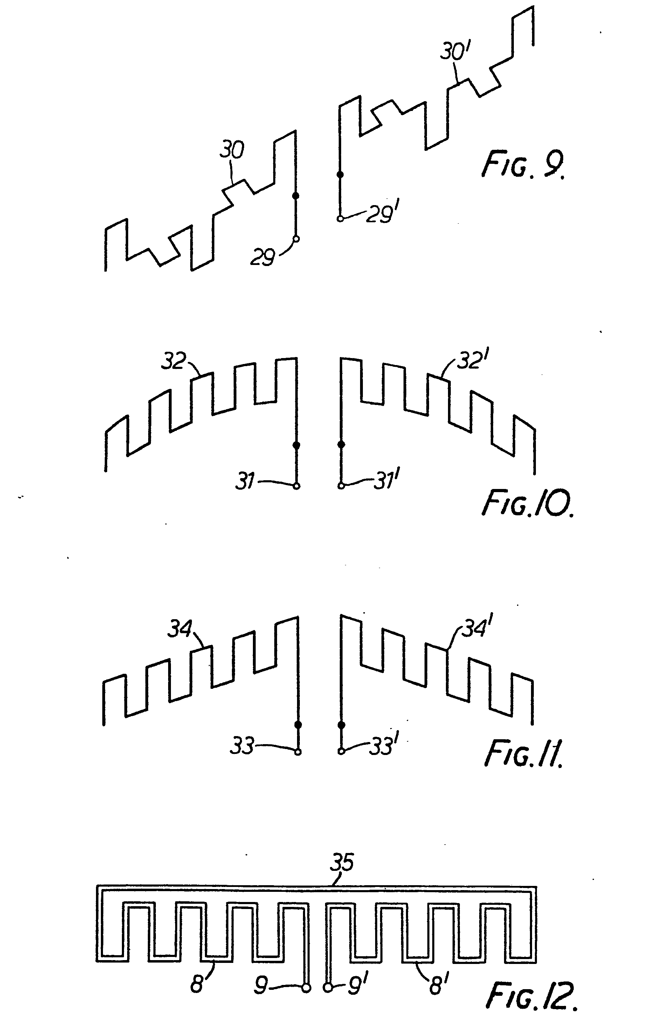

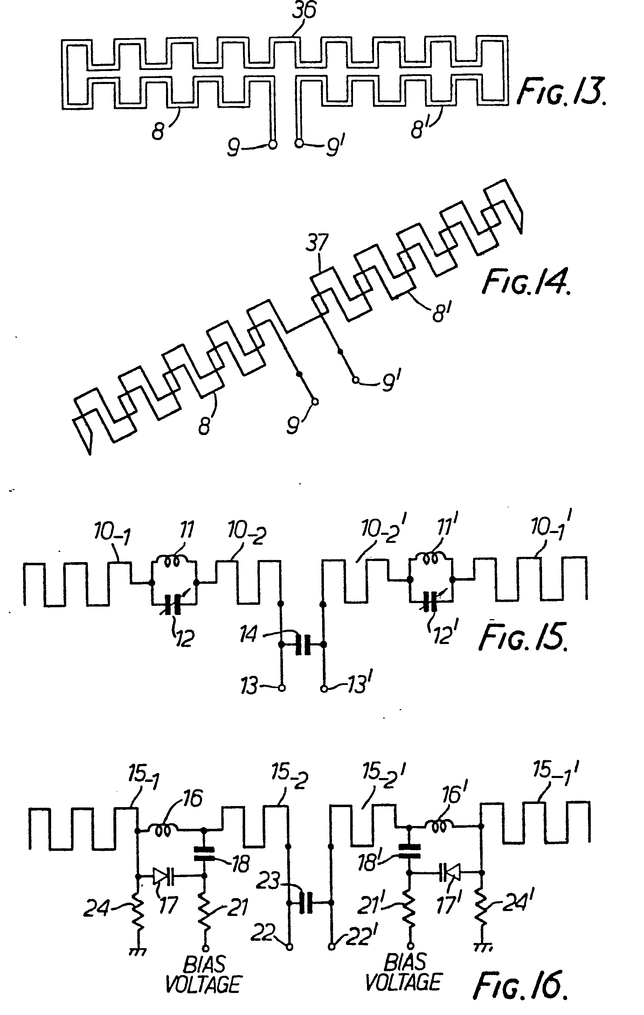

The aforesaid arrangements have pairs of antenna elements 10, 10' and 15, 15' which are formed of turn-back shape and continuous transmitting conductor ways and have distributed constant impedance, the elements being perpendicular and parallel to the longitudinal direction of the element and bent at right angles at a desired number of points on the same plane; in brief, antenna elements 8, 8' are each formed in a rectangular wave form. Alternatively, antenna elements 26, 26', as shown in Figure 7 may be used, which have feed terminals 25, 25' and comprise transmitting conductor ways of sine-wave-like turn-back shape. Furthermore, as shown in Figure 8, antenna elements 28, 28' having feed terminals 27, 27' may be used and which are doubled in the same plane. Antenna elements 30, 30', shown in Figure 9, have feed terminals 29, 29' and are of spirally twisted construction. As another alternative, antenna elements 32, 32', as shown in Figure 10, having feed terminals 31, 31' are constructed in a circular arc. As a further alternative, antenna elements 34, 34', as shown in Figure 11, and having feed terminals 33, 33' are constructed in an inverted V-like shape. Figure 12 shows a modification of the arrangement of Figure 2 in which the elements 8, 8' are connected at their extreme ends with reference to the feed terminals 9, 9' by a symmetrical transmitting conductor way 35. Alternatively, as shown in Figure 13, they can be connected by a symmetrical transmitting conductor route 36 of rectangular wave-form in a single plane. Still further, connection can be achieved by a symmetrical transmitting conductor route 37 of rectangular wave-form in a three-dimensional manner as shown in Figure 14, thereby being usable as a turn-back dipole antenna. In the above embodiments, the variable reactance circuit is connected to the feeding side of each antenna element. Alternatively, the variable reactance circuit may of course be insertably connected within the antenna elements as shown in Figures 15 and 16.

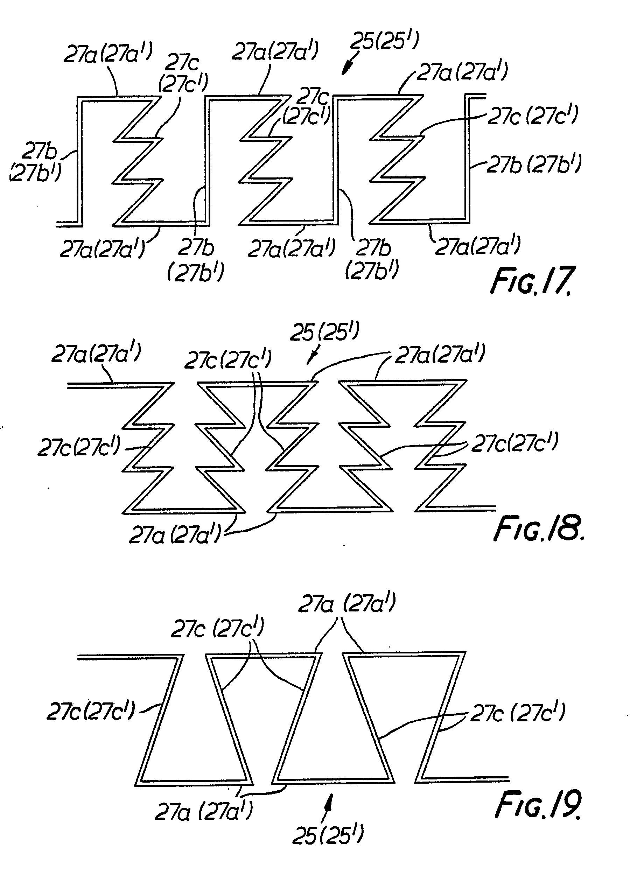

Figure 17 shows a further example of antenna element, in which contracted elements 25 and 25' (hereinafter referred to merely as elements 25, 25') employ metallic foil or wire, such as copper, aluminium or iron, of low electric resistance, or conductive foil on a printed base. The elements 25, 25' are bent at the required points, in the respective directions and at angles the required number of times. The elements 25, 25' are subjected to distributed constant inductance caused by the arrangement in continuation of the conductors which are distributed alternately lengthwise of and perpendicular to the elements at the bending points and between each bending point. Hence, the elements 25, 25' are equivalent to the elements in the conventional example shown in Figures 1(a) and 1(b).

The elements 25, 25' comprise conductors 27a, 27a' extending horizontally and lengthwise and conductors 27b, 27b' extending perpendicular to the conductors 27a, 27a', the conductors 27a, 27a', 27b, and 27b' being arranged in continuation and in rectangular wave-form. In such elements 25, 25', the conductors 27b, 27b' extending perpendicularly, as shown in Figure 17, include conductors 27c, 27c' which are bent zigzag the required number of times and are therefore longer than the conductors 27b, 27b'. The elements 25, 25' are formed symmetrically to each other, i.e. in mirror image, with respect to the feed terminals. In this arrangement, the elements 25, 25' may consist of only one of pairs of the conductors generally perpendicular to the longitudinal direction of elements being bent zigzag and the other being straight; alternatively, both the perpendicular conductors may be bent zigzag as shown in Figure 18, which is a convenient way of eliminating the flux component. As shown in Figure 19, just one zigzag bend may be provided for each conductor, as opposed to the plurality of bends previously described.

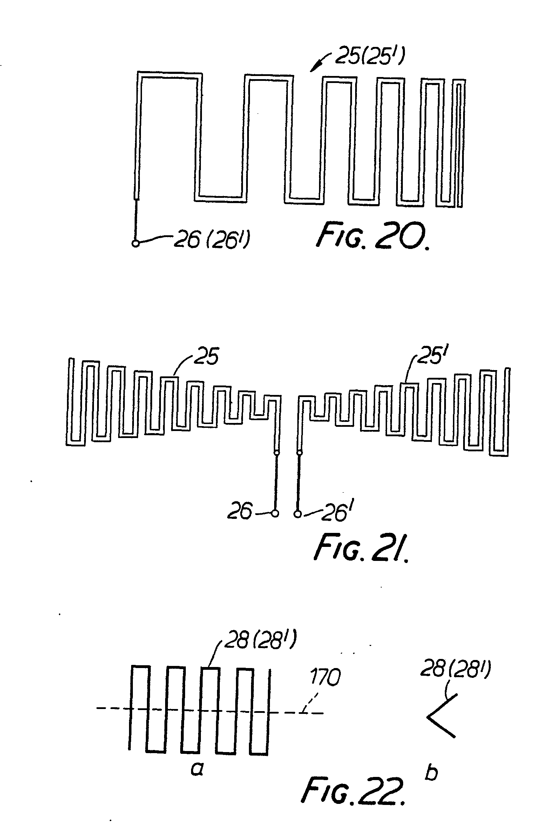

Figure 20 shows an arrangement wherein each element 25 or 25' includes conductors having gradually decreasing spacing between adjacent conductors with increasing distance from the feed terminal 26 or 26', so that intervals between bending points become gradually closer in that direction. Figure 20 shows just one element usable as a monopole antenna. Alternatively, two may be provided to form a dipole. In Figure 21, the conductors are formed in a pattern wherein intervals between the bending points are arranged such that the turn-back portions, i.e. transverse to the longitudinal axis, have gradually increasing length in the transverse direction with increasing distance from the feed terminals 26, 26'. This provides a top loading effect. The two-terminal variable reactance circuit, which is provided at the feeding sides of elements 25, 25' in the above arrangement, may altermatively be interposed within the antenna elements 25, 25' and connected thereto as previously discussed.

Figure 22 shows still another example of antenna element in which contracted antenna elements 28, 28' have distributed constant inductance.

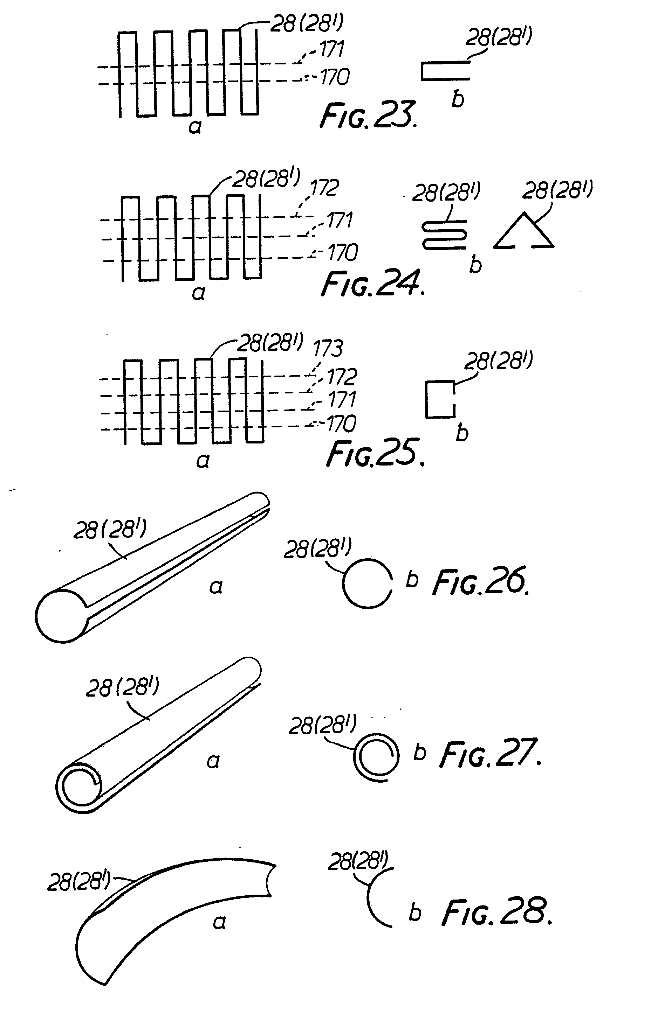

In this instance, the elements 28, 28' are bent at a given angle around the broken line 170 and formed in a V-like shape extending lengthwise of the elements 28, 28', in which the element pattern is convoluted thereby to significantly restrict the generation of flux in comparison with usual coils. The elements 28, 28', if composed of metallic foil or wire, may be kept in the bent condition by a base coincident with the bending configuration, and, if composed of metallic foil on a printed base, may employ a flexible base. Alternatively, the elements 28, 28' may be bent at broken lines 170, 171 as shown in Figure 23(a) and may be formed in a U-like shape as shown in Figure 23(b); may be bent at the broken lines 170, 171 and 172 as shown in Figure 24(a) to be formed in an approximately W-like shape or nearly in a triangular shape as shown in Figure 24(b); or may be bent at the broken lines 170, 171, 172 and 173 as shown in Figure 25(a) and formed in a rectangular shape as shown in Figure 25(b). Still further, the elements may be formed in a rolled shape as shown in Figures 26(a) and 26(b), other than the above angular shape, in an overlapped rolled shape as shown in Figures 27(a) and 27(b), or in a circular arc as shown in Figures 28(a) and 28(b).

Furthermore, the antenna elements can be attached to a transparent flexible base when in a planar configuration, whereupon the base can be stuck to window glass, which is useful especially for an antenna device for a car radio.

The antenna elements can actually be produced by etching the print base or punching the metallic foil, thereby being easy to produce and inexpensive. When using a printed base, the element and circuitry can be formed in a pattern simultaneously on the same base, thereby enabling integral formation.

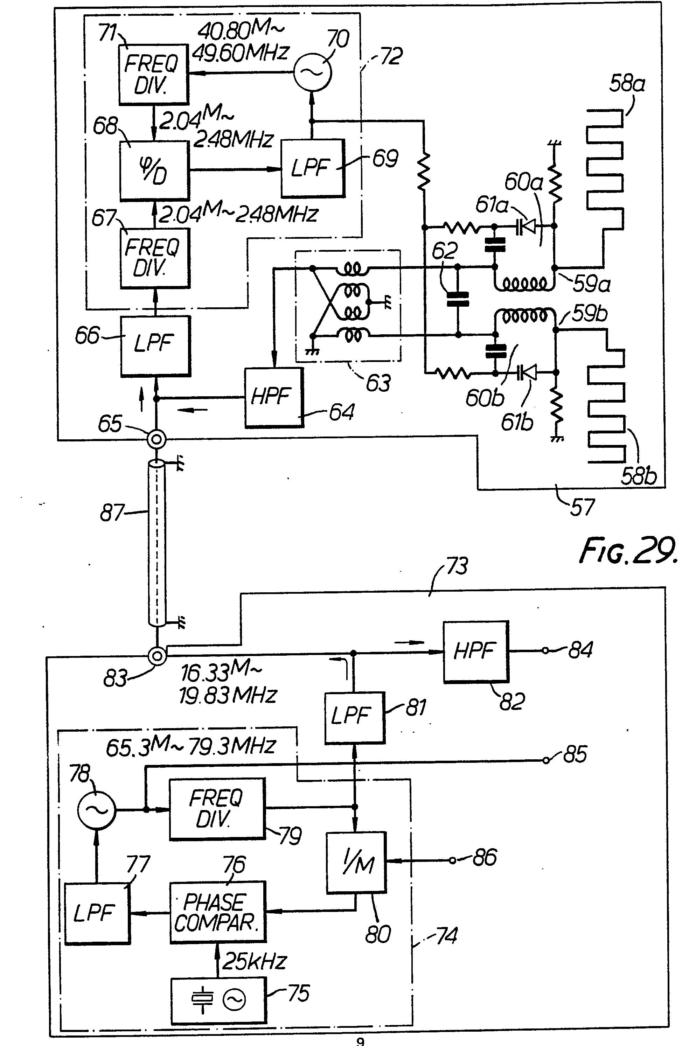

Figure 29 shows an embodiment of the invention which comprises an antenna circuit 57 connected to a receiver 73 via a coaxial cable 87.

The antenna circuit 57 includes a pair of antenna elements 58a, 58b comprised of bent conductors distributed alternately lengthwise of or perpendicular to the elements and arranged in continuation to thereby generate distributed constant inductance. Since the distributed constant inductance can eliminate reactance at the antenna elements 58a, 58b, the impedance viewed from feed terminals 59a, 59b is made to be a given value at the required frequency. The antenna elements 58a, 58b can be constituted by any of the shapes and constructions described previously. Variable reactance circuits 60a, 60b are connected to feed terminals 59a, 59b respectively, and the circuits have variable capacity diodes 61a, 61b as variable elements. The resonance frequency fr of variable reactance circuits 60a, 60b, which is controlled to vary the capacity values at diodes 61a, 61b is set to enable control of the reactance component at the antenna elements 58a, 58b. In addition, a capacitor 62 is connected between the feed terminals 59a, 59b for adjusting impedance. A balance-unbalance converter 63 is connected between the capacitor 62 and a high-pass filter 64 for passing therethrough the high-frequency received signal. The output of the filter 64 is connected to an output terminal 65 which is also connected to a low-pass filter 66 for passing therethrough a control signal from the receiver 73 to a frequency divider 67 and thence to a loop comprising a phase detector 68, a low-pass filter 69, a voltage controlled oscillator (VCO) 70 and a frequency divider 71, so that this loop constitutes a well-known phase-locked loop (PLL) circuit, and the PLL circuit and frequency divider 67 constitute a frequency discriminator 72.

The high-frequency stage of the receiver 73 comprises a synthesizer unit 74 including another PLL circuit in the form of a reference oscillator 75, a phase comparator 76, a low-pass filter 77, a voltage controlled oscillator (VCO) 78, a frequency divider 79, and a program counter 80 controlled by a signal applied to a terminal 86. The receiver also includes a low-pass filter 81 for passing therethrough the output signal of the frequency divider 79, a high-pass filter 82 for passing therethrough the high-frequency received signal from the antenna circuit 57, an input terminal 83 to the receiver, a terminal 84 connected to the front end (not shown) allows the received signal to pass from the filter 82, a terminal 85 connected to the mixer (not shown) and the terminal 86 receives the code signal for setting the receiving frequency by means of the program counter 80. The output terminal 65 at the antenna circuit 57 and input terminal 83 at the receiver 73 are connected together through the high-frequency coaxial cable 87.

In order to provide the required control of the antenna circuit 57 by the receiver 73, the output of the frequency divider 79 of the synthesizer unit 74 provided in the receiver 73 is adapted to be used as the control signal. In detail, the control signal is fed to the antenna circuit 57 by way of the low-pass filter 81, input terminal 83 and coaxial cable 87, and is applied to the frequency divider 67 by way of the low-pass filter 66, and, after being stepped down to the required frequency, is applied to PLL circuits 68 to 71, so that a d.c. voltage corresponding to the frequency of the control signal is derived from the output side of the low-pass filter 69 and applied to the variable capacity diodes *61a, 61b*. By this means, remote control of tuning of the antenna circuit is possible from the receiver 73. The high-frequency received signal from antenna circuit 57 is output to the terminal 65 through the high-pass filter 64 and fed to the front end (not shown) of the receiver 73 through the coaxial cable 87, input terminal 83, high-pass filter 82 and terminal 84. The numerals in Figure 29 represent exemplary frequencies within the FM band (receiving frequency 76 MHz to 90 MHz) in Japan, and the corresponding divided frequencies appearing at different parts of the circuit.

Alternatively, the frequency discriminator 72 may employ a pulse-count wave-detector, Foster-Seeley type wave-detector, ratio type wave-detector, double staggered resonance type wave-detector, or slope wave-detector. When the division ratio of frequency divider 67 is properly set, the output of the VCO 70 may be used directly as the control signal. The variable reactance circuits *60a, 60b* may be connected to positions other than shown.

As seen from the above, an antenna system in accordance with the invention is so constructed that small-sized antenna elements can be utilised in conjunction with the frequency discriminating circuit, and the VCO output or frequency division output thereof in the synthesizer receiver is supplied as the tuning control signal to the frequency discriminating circuit, so that the d.c. voltage output by the frequency discriminating circuit is applied to the variable capacity diodes provided at the antenna circuit, thereby making possible remote-controlled antenna tuning from the receiver for superior receiving ability.

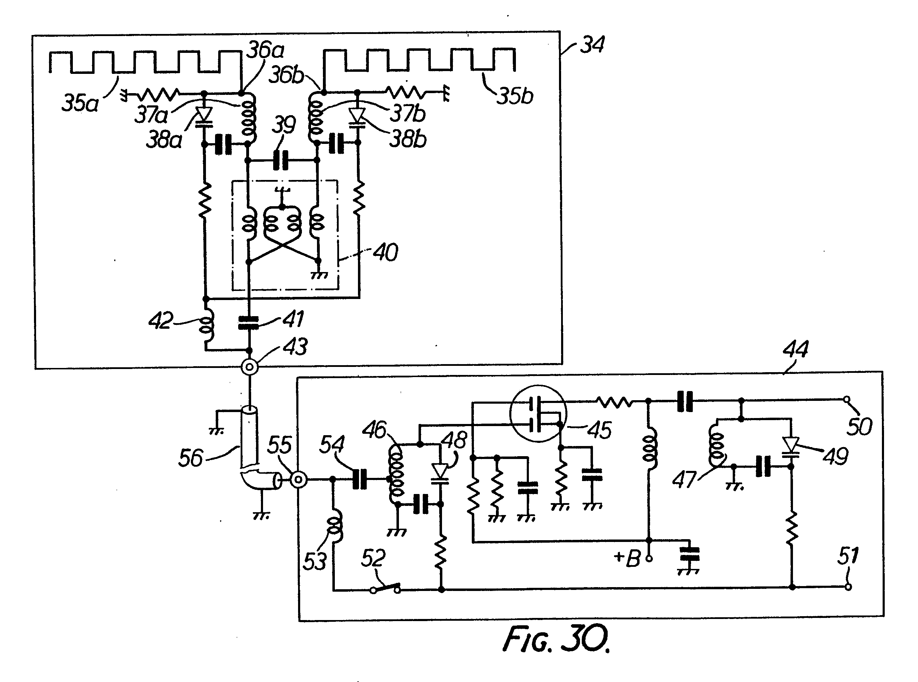

Figure 30 shows part of a modified embodiment of the invention. In this embodiment, the antenna circuit includes circuitry 34 proximal to and including the antenna elements *35a, 35b;* the antenna circuit further includes an amplifier 44 for selectively boosting the high frequency received signals provided by the antenna elements. Most of the features of circuitry 34 have already been described in relation to the embodiment of Figure 29 and will not be further discussed. The amplifier 44 includes a high-frequency amplifying device 45 and variable capacity diodes 48, 49 are interposed within resonance circuits 46, 47 respectively. A terminal 50 is connected to a receiver (not shown) and a terminal 51 has applied thereto a bias voltage for the variable capacity diodes 48 and 49. A high-frequency choke coil 53 and capacitor 54 respectively act to pass d.c. signals and high-frequency signals, and an input terminal 55 is provided to the amplifier 44.

The output terminal 43 of the circuit 34 and the input terminal 55 at the amplifier 44 are connected with each other through a high-frequency coaxial cable 56.

In this embodiment, bias voltage applied to the variable capacity diodes 48, 49 from the terminal 51 of amplifier 44 is also applied to the variable capacity diodes *38a, 38b* at the circuit 34 through a switch 52, high-frequency choke coil 53, input terminal 55, high-frequency coaxial cable 56, input terminal 43, and high-frequency choke coil 42, thereby changing the resonance frequency *fr* of variable reactance circuits *37a, 37b*, thus enabling the circuit 34 to tune by remote control in tandem with the amplifier 44. In this instance, the high-frequency received signal from circuit 34 is of course transmitted to the amplifier 44 through the capacitor 41, input terminal 43, high-frequency coaxial cable 56, input terminal 55 and capacitor 54.

In addition, in this embodiment it is desirable that the variable capacity diodes *38a, 38b* of circuit 34 should have similar characteristics to the variable capacity diodes 48, 49 of the amplifier 44.

Alternatively, the variable reactance circuits *37a, 37b* may be interposed in other positions at antenna elements *35a, 35b* or formed by a series resonance circuit. Resistances of about 100 KΩ instead of the choke coils 42, 53 can be used to obtain the same effect. The switch 52 can be kept open when a normal (full length) antenna is used with the receiver.

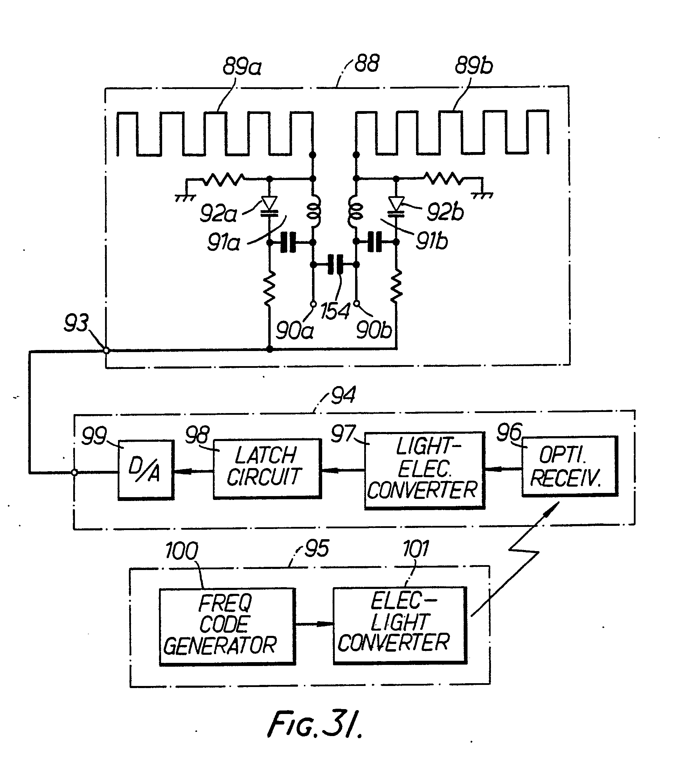

Figure 31 shows part of a further modification of the basic embodiment of the invention. The antenna circuit includes circuitry 88 similar to that previously described and which will therefore not be discussed further; it also includes a first control circuit 94.

As shown in Figure 31, first and second control circuits 94, 95 are constituted as follows. The first control circuit 94 comprises an optical receiver 96 receiving optical codes, a light-electricity converter 97 for converting the output of the optical receiver 96 into an electrical signal, a latch circuit 98 to latch the output of the converter 97, and a digital-to-analog converter 99 to convert the output of latch circuit 98 into an analog voltage. The second control circuit 95 comprises a code generator 100 to generate codes for setting frequency and an electricity-light converter 101 for converting the codes into light (preferably infrared rays).

In operation, this embodiment converts a code for setting frequency into an optical code, the optical code is converted into a code represented by the electrical signal which is latched and then transformed into an analog voltage, thereafter being applied to variable capacity diodes *92a, 92b*.

Hence, a digital signal is usable to control the tuning of the small-sized antenna. The first and second control circuits 94, 95 enable remote control. Furthermore, when the first control circuit 94 is incorporated within the antenna circuit and the second control circuit 95 only is apart therefrom, or both the first and second control circuits are apart from the antenna circuit, remote control is still possible, thereby considerably increasing design freedom. Moreover, the frequency code generator 100 when used for controlling the variable frequency divider at PLL of synthesizer tuner as a code generator for setting the frequency, can be simply added to a conventional synthesizer tuner.

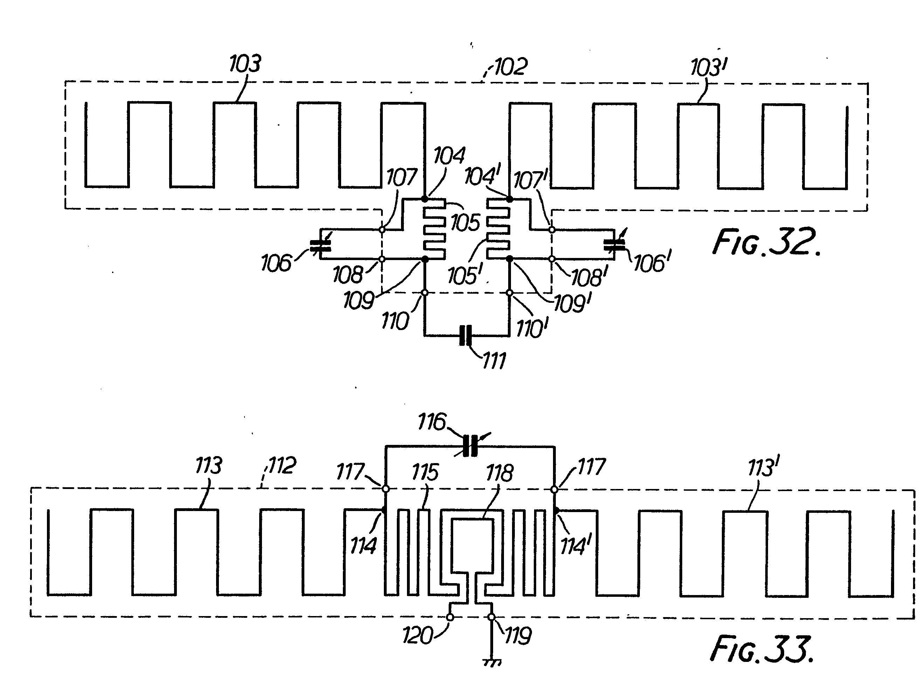

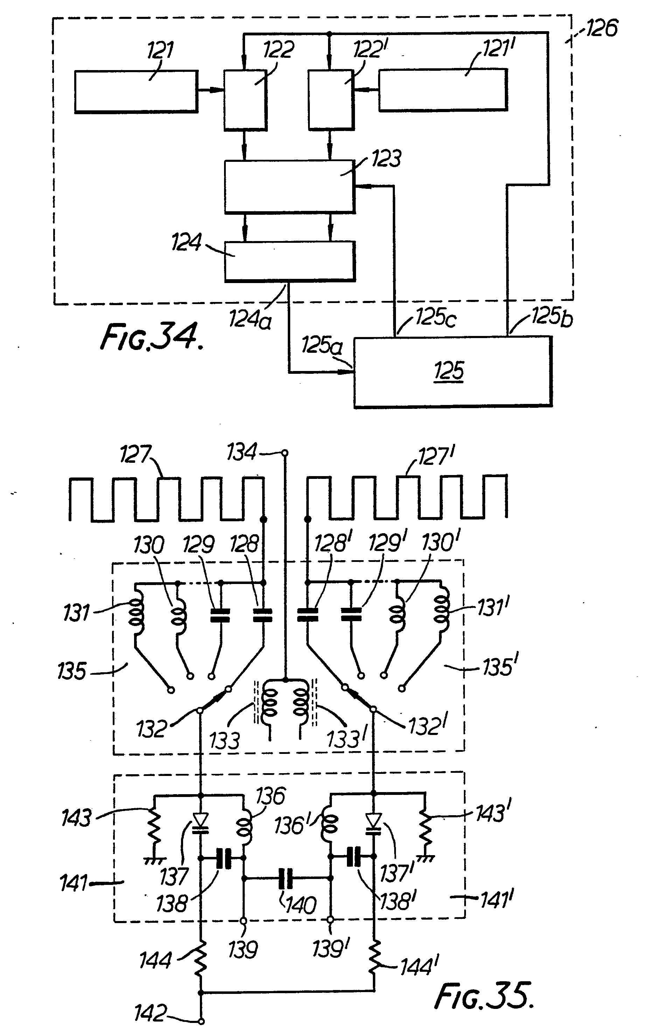

Figures 32 and 33 show different arrangements of antenna elements.

In Figure 32, on a base 102 of print wirings are printed antenna element patterns 103, 103' and distributed constant inductance coils 105, 105' as inductance of components for tuning circuits connected to pattern joints 104, 104' at the feed terminal side of element patterns 103, 103'. On the print base 102 are also printed lead wire routes from the joints 104, 104' to terminals 107, 107' connected to variable capacitive elements 106, 106', lead wire routes from the other terminals 108, 108' connected to the other pattern joints 109, 109', and lead wire routes from the pattern joints 109, 109' to feed terminals 110, 110'. An impedance adjusting capacitor 111 is connected between the feed terminals 110 and 110'. The variable capacitive elements 106, 106', other components of tuning circuits, and the impedance adjusting capacitor 111 are mounted at lead terminals at both ends directly on the lead wire routes between the terminals 107, 107' and 110, 110', or inserted into bores bored at the lead wire routes.

Figure 33 shows a yet further embodiment of antenna system. In Figure 33, on a print-wiring base 112 are printed antenna element patterns 113, 113' having the distributed constant inductance, and is printed a distributed constant inductance coil 115 serving as inductance of component in the tuning circuit and connected between pattern joints 114 and 114' at the feeding side of element patterns. On the print-wiring base 112 also are printed lead wire routes extending up to a terminal 117 connecting a variable capacitive element 116, is printed a lead wire route extending from the other terminal 117' connecting the variable capacitive element 116 with the pattern joint 114', the other end of the inductance coil 115, and lead wire routes are printed connecting to an earth terminal 119 and feed terminal 120 the secondary coil 118, which together with the primary coil 115 forms a transformer. The transformer is provided with a balance-unbalance mode change function as well as an impedance change function. The variable capacitive element 116 is mounted at both end lead terminals directly on the lead wire routes to joints 117, 117', or inserted into bores formed at the routes.

In addition, in the above embodiment, antenna elements 103, 103', 113 and 113' and inductance coils 105, 105' and 115, each formed in a simple zigzag pattern, may of course be formed of a desired pattern having a required inductance value.

The above arrangements provide an antenna of very low production cost. Elements and coils are mass-produced in the same pattern. Also, the elements and coils, which are of plane patterns of distributed constant inductance and without closed current loops, generate no magnetic flux. On the contrary, they are not affected by external magnetic flux and these distributed constant inductance elements or coils can decrease losses more than those of concentrated constant inductance, thereby being very advantageous in improving gain, stability, and reliability.

Figures 34 to 37 are views explanatory of further antenna systems in which band change-over and tuning at the antenna and receiver are associated with each other so that tracking for the antenna and receiver is always carried out over a wide range of tuning frequencies without changing a fixed number of parts constituting the antenna elements and tuning circuits.

Generally, in antennas of the tuning type, the impedance possessed by antenna elements and a range of variable adjusting tuning circuits connected to the elements, are determined by each structural form or material and are limited thereto. Hence, these tuning antennas have a limited tuning frequency range, whereby it is inconvenient to carry out tracking in connection with other tuning systems.

Figure 34 is a block diagram of a basic constitution of receiving device, in which reference numerals 121, 121' designate antenna elements to which change-over control reactance circuits 122, 122' are connected. A tuner 123 and a balance-unbalance mode converter 124 (hereinafter referred to merely as balance) are connected to the change-over control reactance circuits 122, 122'. An unbalance output terminal *124a* at the balance 124 is connected with an antenna input terminal *125a* of receiver 125 through a coaxial cable. The band change-over signal itself obtained by change-over of receiving band at the receiver 125, or band change-over control signal converted into deisred signal form, is output from a band change-over control signal output terminal *125b* at the receiver 125 by way of a line and then fed to the change-over control reactance circuits 122, 122'. The change-over control reactance circuits 122, 122' set positive and negative values of reactance and a value of reactance corresponding to the band change-over control signal, the set reactance being added in series to the antenna elements 122, 122'. Tuning control signal itself obtained by the setting of tuning frequency at receiver 125, or tuning control signal converted into the desired signal form, is output from a tuning control signal output terminal *125c* at receiver 125 through the line and fed to the tuner 123, whereby, in the set band, the receiver 125 and antenna unit 126 are synchronised to maintain tracking. In the above description, the dipole antennas are exemplified by a pair of antenna elements 121, 121'. Alternatively, a mono-pole type antenna of singla antenna element may be applicable. Instead of the balance 124 converting the unabalance output signal, the balance output signal in unmodified form may be fed to the receiver 125 providing a balance antenna input terminal. Also, the change-over control reactance circuits 122, 122' may be disposed at intermediate positions within the antenna elements 121, 121' respectively.

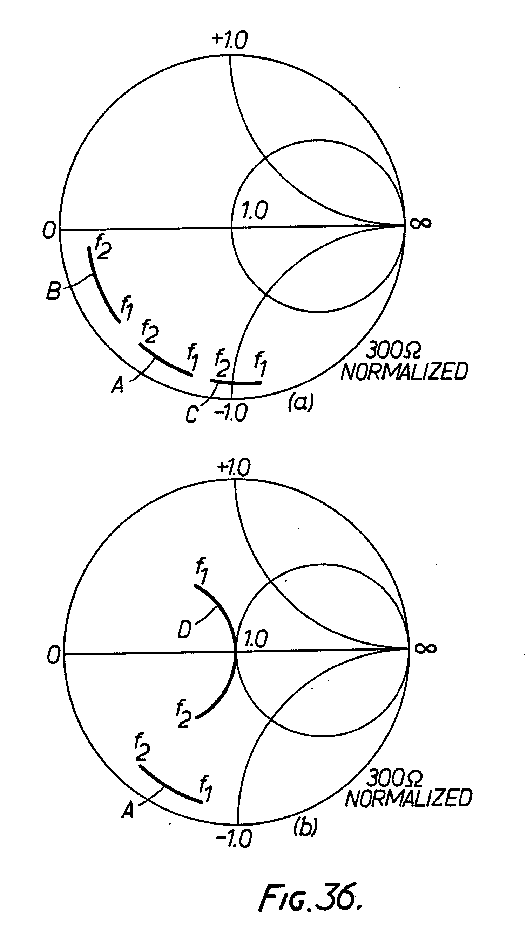

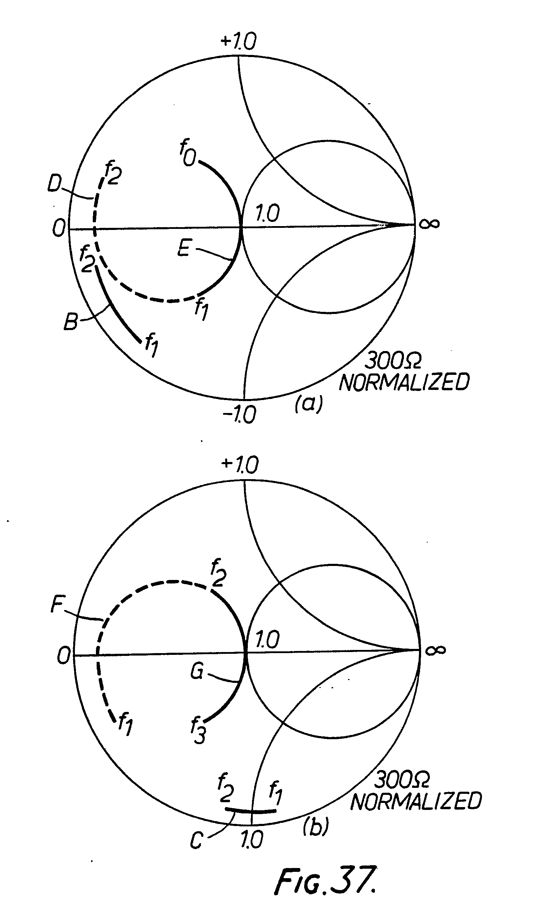

In Figure 35, only the impedance at frequencies $f_1$ to $f_2$ of distributed constant inductance elements 127, 127' is represented by a curve A in Figure 36b. Fixed capacitors 128, 128', 129 and 129' and fixed coils 130, 130', 131 and 131' are connected to the elements. Change-over control reactance circuits 135, 135' comprising change-over switches i.e. switches 132, 132' and exciting coils 133, 133' and being changed over to a required change-over terminal, are connected to the elements, so that, for example, when the switches 132, 132' are changed over to connect the fixed coils 131, 131', the impedance follows the curve B in Figure 37. Where a tuning circuit 141 is interposed between the parallel resonance variable reactance circuits comprising coil 136, variable capacitor 137, capacitor 138, coil 136', variable capacitor 137', and capacitor 138', and the feed terminals 139, 139', the tuning circuit 141 including an impedance adjusting capacitor 140, the impedance at $f_1$ to $f_2$ changes until the curve D shown by the broken line in Figure 37(a), alternatively becomes tunable in a frequency range of $f_0$ to $f_1$ lower than $f_1$ to $f_2$ shown by the curve E. On the other hand, in Figure 35, when the switches 132, 132' are changed over to connect to the distributed constant inductance elements 127, 127', for example, the fixed capacitors 128, 128', the impedance changes to the curve C in Figure 37(b). Furthermore, when the tuning circuit 141 comprising impedance adjusting capacitor 140 is connected between the feed terminals 139, 139' and the parallel resonance variable reactance circuits comprising the coil 136, variable capacitor 137, capacitor 138, coil 136', variable capacitor 137', and capacitor 138'; the impedance at $f_1$ to $f_2$ changes to the curve F as shown by the brokwn line in Figure 37(b) and alternatively becomes tunable in a frequency range of $f_2$ to $f_3$ higher than $f_1$ to $f_2$

shown by the curve G, where the variable capacitors 137, 137' change in value of electrostatic capacity by virtue of the tuning control signal applied to the terminal 142, and resistances 143, 143', 144 and 144' are provided for blocking high-frequencies. When the reactance of each fixed coil 130, 130', 131, 131' is set independently to a desired value, the coils are changed over to make it possible to optionally select a range of tunable frequency. In order to get tracking at receiver 125 and tuning frequency in Figure 34, a band change-over control signal corresponding to band change-over within the receiver 125 is provided on the terminal 134, and the tuning control signal corresponding to the tuning control to the terminal 142. In addition, in the above arrangement, four kinds of fixed capacitors and fixed coils are represented, but plural kinds thereof may of course be provided corresponding to the required change-over bands.

In the above description, parallel resonance variable reactance circuits are used in the tuning circuit 141. Alternatively, series resonance variable reactance circuits may of course be used.

It will be seen that in the previously described arrangements, the receiving device is very wide in tuning frequency range. The consequence is that a number of widely differing bands, such as the FM stereo band, VHF TV band, and UHF TV band for public welfare receiving, can be receivable by a single receiving device comprising an antenna unit and receiver to thereby eliminate the inconvenience of receiving by separate antenna units and receivers for each band. In particular, the use of the zigzag type contracted antenna elements can provide a very small-sized antenna unit of high working gan thus leading to high efficiency.

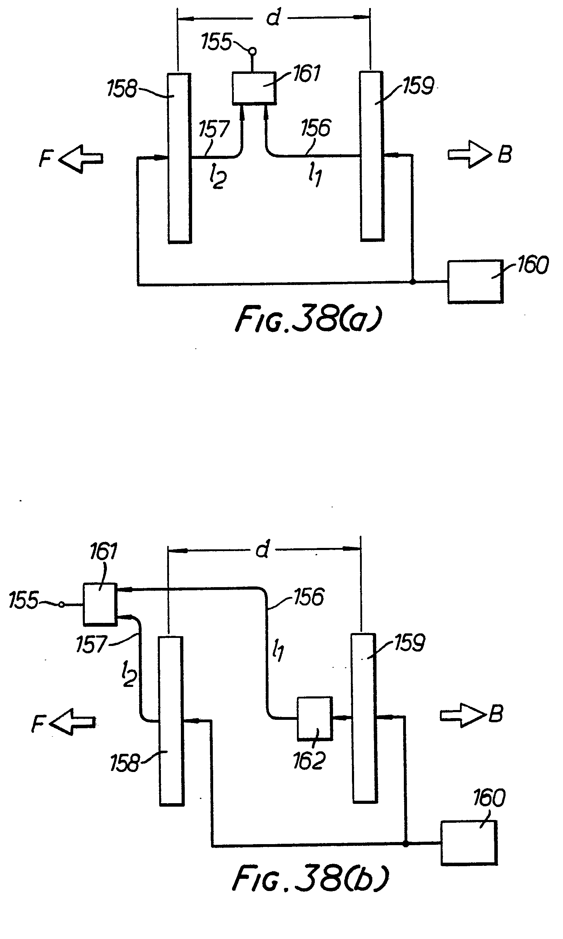

Figures 38(a), 38(b) and 41 are views explanatory of further arrangements.

Figure 38(a) shows an embodiment of a phase difference feed type antenna device of the invention, in which refernce numerals 158, 159 designate a first and a second dipole antenna opposite to each other at a distance $d$, 160 designates a control means in common to the first and second dipole antennas 158, 159, and 161 designates signal composing means connected to the first and second dipole antennas 158, 159. The second dipole antenna 159 is disposed at a phase difference of 180° with respect to the first dipole antenna 158, both the dipole antennas being coupled with signal composing means 161 through coaxial cables 156, 157 each of different length, so that the signal is led to a feed terminal 155 of signal composing means 161.

Now, if the first dipole antenna 158 is disposed at the front F side and the second one 159 at the back B side and lengths of coaxial cables 156, 157 are represented by $l_1$, $l_2$ respectively, the distance $d$ between the opposite dipole antennas 158, 159 can be obtained by the following equation (1):

$$d = K(I_1 - I_2) \qquad (1)$$

where K is the wave-length contraction rate of 0.68 and $I_1 > I_2$.

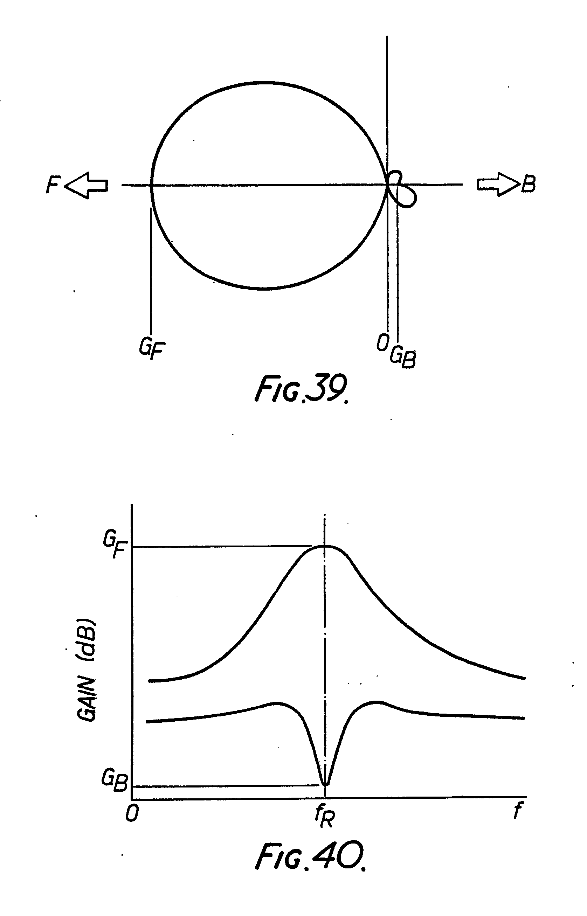

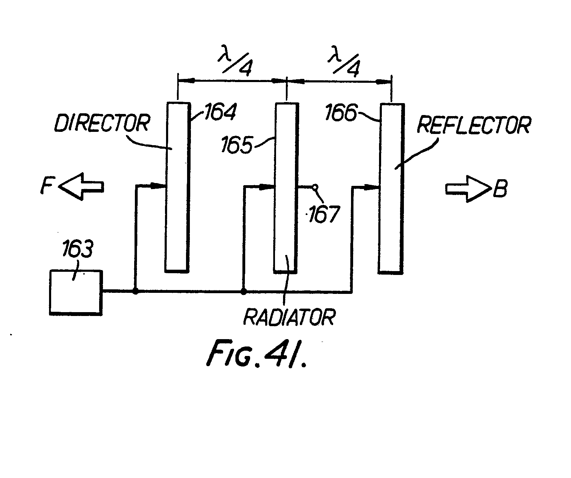

Directivity of such phase difference feed type antenna device is shown in Figure 39 and the frequency to gain characteristic in Figure 40.

In addition, as shown in Figure 38(a), the first and second dipole antennas 158, 159 are disposed opposite to each other at phase difference of 180°. Alternatively, as shown in Figure 38(b), both the dipole antennas 158, 159 may be disposed opposite in-phase so that the second dipole antenna may be connected to the signal composing means 161 by way of a phase converter 162.

Figures 42 to 45 are views explanatory of modified antenna arrangements.

Figure 41 shows an antenna device in which reference numerals 164, 165 and 166 designate first, second and third dipole antennas disposed opposite to each other at intervals of $\lambda/4$. The second dipole antenna 165 is used as a radiator so as to have a feed terminal 167. The first dipole antenna 164 is disposed at the front F side of the second dipole antenna 165 as the radiator and is in-phase to the antenna 165, thereby being used as a wave director. The third dipole antenna 166 is disposed at the back $B$ side of second dipole antenna 165 as the radiator and is in-phase to the dipole antenna 165, thereby being used as a reflector. Reference numeral 163 designates control means in common to the first, second and third dipole antennas as the radiator, wave-director and reflector respectively.

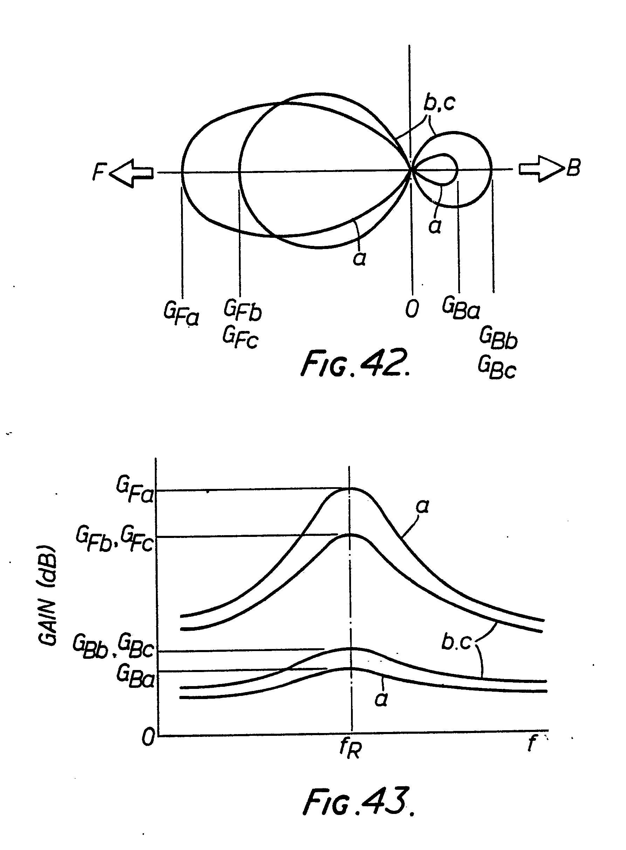

The directivity characteristic of the antenna device using such dipole antennas and having the wave-director and reflector is represented by the curve $a$ in Figure 42, and the frequency to gain characteristic by the curve $a$ in Figure 43.

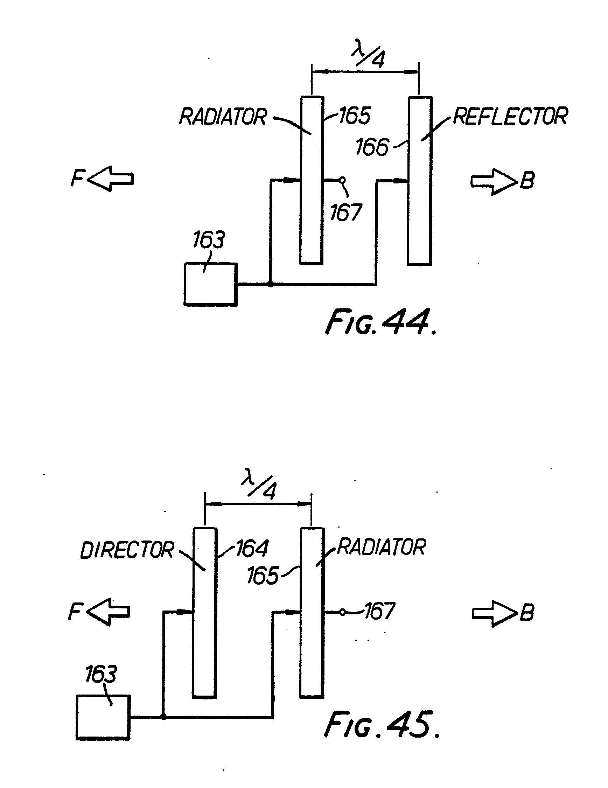

In addition, in the above arrangement, the wave director and reflector are attached to the front and rear of radiator, but at least either wave director or reflector is sufficient as shown in Figures 44 and 45. Their directivity and the frequency to gain characteristics are represented respectively by the curves $b$, $c$ in Figures 42 and 43.

## Claims

1. An electronic tuning antenna system comprising an antenna which includes at least one antenna element (58a) having distributed constant inductance, at least one variable reactance circuit (60a) connected to the or each antenna element, the or each variable reactance circuit including a variable capacity diode (61a), and means for applying a controllable bias voltage to the or each variable capacity diode in response to a control signal provided by a communication apparatus (73) connectable to the antenna system so as to allow passage therebetween of electrical signals associated with conversion between electromagnetic radiation and electrical signals at the antenna, whereby said control signal tunes the antenna system, characterised in that said means for applying a controllable bias voltage comprises a frequency discriminator (72) whose output provides the controllable bias voltage, and in that said communications apparatus (73) includes a phase-locked loop circuit (76—80) generating an oscillating signal at a frequency related to a selected frequency of said electrical signals at the antenna, said oscillating signal being fed to said frequency discriminator to provide said controllable bias voltage.

2. An electronic tuning antenna system according to claim 1, characterised in that said antenna is a dipole antenna comprising two antenna elements (58a, 58b) having associated therewith two variable reactance circuits (60a, 60b) provided with respective variable capacity diodes (61a, 61b), and an impedance adjusting reactance element (62) connected between balanced feed output terminals of the antenna.

3. An electronic tuning antenna system according to claim 1 or 2, characterised in that said frequency discriminator (72) comprises a phase-locked loop circuit (68—71) receiving said oscillating signal from said communications apparatus, said phase-locked loop circuit including a phase detector (68) whose output provides the controllable bias voltage.

4. An electronic tuning antenna system according to claim 1, 2 or 3, characterised in that filter means (64, 66) are provided connecting the antenna and the frequency discriminator (72) to a single co-axial connection means (65) whereby signals fed through a co-axial cable (87) between the connection means (65) and the communications apparatus (73) are separable by said filter means into respective frequency ranges associated with the antenna and the frequency discriminator.

5. An electronic tuning antenna system according to claim 1, 2 or 3, characterised in that an optical receiver (96) is provided for receiving the oscillating signal in light encoded form from a corresponding light transmitter (101) provided in the communications apparatus.

6. An electronic tuning antenna system according to any one of the preceding claims, characterised in that the or each antenna element comprises conductor ways of turnback shape being bent at desired points so as to have distributed constant inductance.

7. An electronic tuning antenna system according to claim 6 as dependent on claim 2, characterised in that the two antenna elements (8, 8¹) are of regular and symmetrical turnback shape and are connected together by a conductor portion (35) at their ends opposite to the feed terminal ends (9, 9¹).

8. An electronic tuning antenna system according to claim 6, characterised in that the or each antenna element includes zig-zag portions (27c) so as to increase the value of the distributed constant inductance.

9. An electronic tuning antenna system according to claim 6, characterised in that the turnback portions of the or each antenna element (25) have gradually decreasing spacing between adjacent portions with increasing distance from the feed terminal end (26).

10. An electronic tuning antenna system according to claim 6, characterised in that the turnback portions of the or each antenna element (25) have gradually increasing width transverse to the longitudinal axis of the antenna element with increasing distance from the feed terminal end (26).

11. An electronic tuning antenna system according to any one of claims 6 to 10, characterised in that the or each antenna element (28) is formed in a planar configuration which is bent along at least one line (170) parallel to or along the longitudinal axis of the antenna element.

12. An electronic tuning antenna system according to any one of claims 6 to 10, characterised in that the or each antenna element (28) is formed in a planar configuration which is curved around the longitudinal axis of the antenna element to form an at least partially cylindrical shape.

13. An electronic tuning antenna system according to any one of the preceding claims, characterised in that the or each antenna element (103), an inductance (105) of the variable, reactance circuit, connecting points for other components, and connections therebetween are provided as printed conductors on a printed circuit base (102).

14. An electronic tuning antenna system according to any one of the preceding claims, characterised in that the or each variable reactance circuit further includes a band changing circuit (135) having a plurality of selectably switchable reactance elements (128—131), said band changing circuit being responsive to a band changing signal from said communications apparatus to selectably switch in a required reactance element, thereby to ensure that said antenna system and said communications apparatus coincide in tuning frequency over a plurality of frequency bands.

15. An electronic tuning antenna system according to claim 2, or any one of claims 3 to 14 as dependent on claim 2, characterised in that said antenna system comprises first and second dipole antennas (158, 159) disposed with a predetermined spacing therebetween, a signal composing device (161) being connected through respective feedways (156, 157) to said antennas, said means for applying a controllable bias voltage being responsive to said control signal to apply bias voltage to the variable capacity diodes associated with said first and second antennas.

16. An electronic tuning antenna system according to claim 15, characterised in that a phase converter (162) is provided between said second dipole antenna (159) and said signal composing device (161), said first and second dipole antennas being disposed so as to be mutually in-phase.

17. An electronic tuning antenna system according to claim 2, or any one of claims 3 to 14 as dependent on claim 2, characterised in that said antenna system comprises a radiator dipole antenna (165) and at least one further dipole antenna acting as a director (164) and/or reflector (166), said antennas being spaced apart by a quarter of the wavelength in use, variable reactance circuits being associated with each of said antennas, said controllable bias voltages being applied to each of said antennas, said radiator dipole antenna (165) having a feed terminal (167) for electrical signals at a frequency tuned by said antenna system.

18. An electronic tuning antenna system according to any one of the preceding claims, characterised in that a frequency-selective amplifier (44) is connected to the or each variable reactance circuit (37a, 37b) for amplifying the electrical signals associated with electromagnetic radiation conversion, and the controllable bias voltage for the variable capacity diodes (38a, 38b) is applied additionally to the amplifier (44) thereby enabling co-operative tuning of the antenna system and the amplifier (44).

**Patentansprüche**

1. Elektronisch sich abstimmendes Antennensystem mit einer Antenne, die wenigstens ein Antennenelement (58a) von verteilter konstanter Induktanz aufweist, wenigstens einem mit dem oder jedem Antennenelement verbundenen Schaltkreis (60a) von veränderbarer Reaktanz, wobei der oder jeder Schaltkreis von veränderbarer Reaktanz eine veränderbare Kapazitätsdiode (61a) aufweist, und einer Vorrichtung, die der oder jeder veränderbaren Kapazitätsdiode eine steuerbare Vorspannung zuführt in Abhängigkeit von einem Steuersignal das von der Kommunikationsvorrichtung (73) geliefert wird, die an das Antennensystem anschließbar ist, um so hierzwischen ein Passieren elektrischer Signale, die einer Umwandlung zwischen elektromagnetischer Strahlung und elektrischen Signalen bei der Antenne zugeordnet sind, zu ermöglichen, wodurch das Steuersignal das Antennensystem abstimmt, dadurch gekennzeichnet, daß die Vorrichtung zum Zuführen einer steuerbaren Vorspannung einen Frequenzdiskriminator (72) aufweist, dessen Ausgang die steuerbare Vorspannung abgibt, und daß die Kommunikationsvorrichtung (73) einen phasenverrasteten Schaltkreis (PLL-Schaltkreis) (76 bis 80) aufweist, der ein oszilierendes Signal mit einer Frequenz erzeugt, die in einer Beziehung steht zu einer gewählten Frequenz der elektrischen Signale bei der Antenne, wobei das oszillierende Signale zum Zwecke des Abgebens der steuerbaren Vorspannung dem Frequenzdiskriminator zugeführt wird.

2. Elektronisch sich abstimmendes Antennensystem nach Anspruch 1, dadurch gekennzeichnet, daß die Antenne eine Dipolantenne ist, die zwei Antennenelemente (58a, 58b), denen zwei Schalktkreise (60a, 60b) von veränderbarer Reaktanz zugeordnet sind, die entsprechende veränderbare Kapazitätsdioden (16a, 61b) aufweisen, und ein zwischen symmetrischen Speiseausgängen der Antenne angeschlossenes Reaktanz-Element (62) zum Justieren der Impedanz aufweist.

3. Elektronisch sich abstimmendes Antennensystem nach Anspruch 1 oder 2, dadurch gekennzeichnet, daß der Frequenzdiskriminator (72) einen PLL-Schaltkreis (68 bis 71) aufweist, der das von der Kommunikationsvorrichtung abgegebene oszillierende Signal erhält und einen Phasendetektor (68) aufweist, dessen Ausgang die steuerbare Vorspannung liefert.

4. Elektronisch sich abstimmendes Antennensystem nach Anspruch 1, 2 oder 3, dadurch gekennzeichnet, daß Filtervorrichtungen (64, 66) vorgesehen sind, die die Antenne und den Frequenzdiskriminator (72) mit einer einzigen koaxialen Verbindungsvorrichtung (65) verbinden, wodurch durch ein koaxiales Kabel (87) zwischen der Verbindungsvorrichtung (65) und der Kommunikations vorrichtung (73) eingespeiste Signale mittels dieser Filtervorrichtungen in entsprechende Frequenzbereiche trennbar sind, die der Antenne bzw. dem Frequenzdiskriminator zugeordnet sind.

5. Elektronisch sich abstimmendes Antennensystem nach Anspruch 1, 2 oder 3, dadurch gekennzeichnet, daß ein optischer Empfänger (96) vorgesehen ist zum Empfangen des in lichtverschlüsselter Form von einen entsprechenden, in der Kommunikationsvorrichtung vorgesehenen Lichtsender (101) abgegeben oszillierenden Signals.

6. Elektronisch sich abstimmendes Antennensystem nach einem der vorangegangenen Ansprüche, dadurch gekennzeichnet, daß das oder jedes Antennenelement Leiterbahnen aufweist, die hin- und hergehend ausgebildet sind, wobei sie an gewünschten Punkten abgebogen sind, um so verteilte konstante Induktanz aufzuweisen.

7. Elektronisch sich abstimmendes Antennensystem nach Anspruch 6 in Abhängigkeit von Anspruch 2, dadurch gekennzeichnet, daß die zwei Antennenelemente (8, 8') gleichmäßig und symmetrisch hin- und hergehend ausgebildet sind un an ihren den Speiseanschluß-Enden (9, 9') entgegengesetzten Enden durch ein Leitungsteil (35) miteinander verbunden sind.

8. Elektronisch sich abstimmendes Antennensystem nach Anspruch 6, dadurch gekennzeichnet, daß das oder jedes Antennenelement Zick-Zack-Bereiche (27c) aufweist, um so den Wert der verteilten konstanten Induktanz zu erhöhen.

9. Elektronisch sich abstimmendes Antennensystem nach Anspruch 6, dadurch gekennzeichnet, daß die hin- und hergehenden Bereiche des oder jedes Antennenelements (25) mit zunehmendem Abstand von dem Speiseanschluß-Ende (26) allmählich abnehmenden Zwischenraum zwischen benachbarten Bereichen aufweisen.

10. Elektronisch sich abstimmendes Antennensystem nach Anspruch 6, dadurch gekennzeichnet, daß die hin- und hergehenden Bereiche des oder jedes Antennenelementes (25) mit zunehmendem Abstand von dem Speiseanschluß-Ende (26) allmählich zunehmende Weite quer zu der Längsachse des Antennenelements aufweisen.

11. Elektronisch sich abstimmendes Antennensystem nach einem der Ansprüche 6 bis 10, dadurch gekennzeichnet, daß das oder jedes Antennenelement (28) in einer flächigen Anordnung ausgebildet ist, die um wenigstens eine parallel oder längs der Längsachse des Antennenelements verlaufenden Linie (170) gebogen ist.

12. Elektronisch sich abstimmendes Antennensystem nach einem der Ansprüche 6 bis 10, dadurch gekennzeichnet, daß das oder jedes Antennenelement (28) in einer flächigen Anordnung ausgebildet ist, die um die Längsachse des Antennenelements gekrümmtist, um eine wenigstens teilweise zylindrische Form zu bilden.

13. Elektronisch sich abstimmendes Antennensystem nach einem der vorangehenden Ansprüche, dadurch gekennzeichnet, daß das oder jedes Antennenelement (103), eine Induktanz (105) des veränderbaren Reaktanz-Schaltkreises, Verbindungspunkte für andere Komponenten und Verbindungen hierzwischen vorgesehen sind als gedruckte Leiter auf einem Träger (102) für gedruckte Schaltkreise.

14. Elektronisch sich abstimmendes Antennensystem nach einem der vorangehenden Ansprüche, dadurch gekennzeichnet, daß der oder jeder Schaltkreis von veränderbarer Reaktanz des weiteren einen Bereichsänderungsschaltkreis (135) aufweist, der eine Vielzahl von auswählbar einschlatbaren Reaktanz-Elementen (128 bis 131) aufweist und auf ein von der Kommunikationsvorrichtung kommendes Bereichsänderungssignal anspricht, um auswählbar auf ein erforderliches Reaktanzelement zu schalten, wodurch beim Frequenzabstimmen über eine Vielzahl von Frequenzbereichen gesichert ist, daß das Antennensystem und die Kommunikationsvorrichtung übereinstimmen.

15. Elektronisch sich abstimmendes Antennensystem nach Anspruch 2 oder einem der Ansprüche 3 bis 14 in Abhängigkeit von Anspruch 2, dadurch gekennzeichnet, daß das Antennensystem eine erste und eine zweite Dipolantenne (158, 159) aufweist, die in einem vorbestimmten Abstand zueinander angeordnet sind, wobei eine Signalzusammenführungsvorrichtung (161) durch entsprechende Zuleitungen (156, 157) mit den Antennen verbunden ist und wobei die Vorrichtung zum Zuführen einer steuerbaren Vorspannung auf das Steuersignal anspricht, um den der ersten und der zweiten Antenne zugeordneten steuerbaren Kapazitätsdioden die Vorspannung zuzuführen.

16. Elektronisch sich abstimmendes Antennensystem nach Anspruch 15, dadurch gekennzeichnet, daß zwischen der zweiten Dipolantenne (159) und der Signalzusammenführungsvorrichtung (161) ein Phasenwandler (162) vorgesehen ist, wobei die erste und die zweite Dipolantenne so angeordnet sind, daß sie miteinander in Phase liegen.

17. Elektronisch sich abstimmendes Antennensystem nach Anspruch 2 oder einem der Ansprüche 3 bis 14 in Abhängigkeit von Anspruch 2, dadurch gekennzeichnet, daß das Antennensystem eine Strahler-Dipolantenne (165) und wenigstens eine weitere Dipolantenne aufweist, die als Direktor (164) und/oder Reflektor (166) dient, wobei die Antennen zueinander einen Abstand von einem Viertel der benützten Wellenlänge aufweisen und jeder der Antennen veränderbare Reaktanzschaltkreise zugeordnet sind, wobei die steuerbare Vorspannung jeder dieser Antennen zugeführt wird und die Strahler-Dipolantenne (165) einen Speiseanschluß (167) für elektrische Signale aufweist mit einer durch das Antennensystem abgestimmten Frequenz.

18. Elektronisch sich abstimmendes Antennensystem nach einem der vorangehenden Ansprüche, dadurch gekennzeichnet, daß ein frequenzselektiver Verstärker (44) mit dem oder jedem veränderbaren Reaktanzschaltkreis (37a, 37b) zum Verstärken der mit der elektromagnetischen Strahlungswandlung verbundenen elektrischen Signale verbunden ist und die steuerbare Vorspannung für die veränderbaren Kapazitätsdioden (38a, 38b) zusätzlich dem Verstärker (44) zugeführt ist, wodurch ein zusammenarbeitendes Abstimmen des Antennensystems und des Verstärkers (44) ermöglicht ist.

## Revendications

1. Système d'antenne à accord électronique, comprenant une antenne qui comporte au moins un élément d'antenne (58a) avec une inductance constante distribuée, au moins un circuit à réactance variable (60a) connecté à l'élément ou à chaque élément d'antenne, le circuit ou chaque circuit à réactance variable comprenant une diode à capacité variable (61a) et un dispositif pour appliquer une tension de polarisation contrôlée à la diode ou chaque diode à capacité variable en réponse à un signal de commande produit par un appareil de télécommunication (73) pouvant être connecté au système d'antenne de manière à permettre le passage entre eux de signaux électriques associés avec une conversion entre un rayonnement électromagnétique et des signaux électriques à l'antenne, afin que ledit signal de commande accorde le système d'antenne, caractérisé en ce que ledit dispositif qui applique une tension de polarisation contrôlée comporte un discriminateur de fréquence (72) dont la sortie produit la tension de polarisation contrôlée et en ce que ledit appareil de télécommunication (73) comporte un circuit de boucle à verrouillage de phase (76—80) produisant un signal oscillatoire à une fréquence liée à une fréquence sélectionnée desdits signaux électriques à l'angenne, ledit signal oscillatoire étant appliqué audit discriminateur de fréquence pour produite ladite tension de polarisation contrôlée.

2. Système d'antenne à accord électronique selon la revendication 1, caractérisé en ce que ladite antenne est une antenne dipôle comprenant deux éléments d'antenne (58a, 58b) avec lesquels sont associés deux circuits à réactance variable (60a, 60b) prévus avec des diodes respectives à capacité variable (61a, 61b) et un élément de réactance de réglage d'impédance (62) connecté entre les bornes de sortie d'attaque équilibrée de l'antenne.

3. Système d'antenne à accord électronique selon la revendication 1 ou 2, caractérisé en ce que ledit discriminateur de fréquence (72) comporte un circuit de boucle à verrouillage de phase (68—71) qui reçoit ledit signal oscillatoire provenant dudit appareil de télécommunication, ledit circuit de boucle à verrouillage de phase comprenant un détecteur de phase (68) dont la sortie délivre la tension de polarisation contrôlée.

4. Système d'antenne à accord électronique selon la revendication 1, 2 ou 3, caractérisé en ce qu'un filtre (64, 66) est prévu pour connecter l'antenne et le discriminateur de fréquence (72) à un seul dispositif de connexion coaxial (65) de manière que des signaux transmis par un câble coaxial (87) entre le dispositif de connexion (65) et l'appareil de télécommunication (73) puissent être séparés par ledit filtre en des plages de fréquence respective associées avec l'antenne et le discriminateur de fréquence.

5. Système d'antenne à accord électronique selon la revendication 1, 2 ou 3, caractérisé en ce qu'un récepteur optique (96) est prévu pour recevoir le signal oscillatoire sous forme codée lumineuse provenant d'un émetteur de lumière (101) prévu dans l'appareil de télécommunication.

6. Système d'antenne à accord électronique selon l'une quelconque des revendications précédentes, caractérisé en ce que l'élément ou chaque élément d'antenne comporte des circuits conducteurs de forme repliée, qui sont pliés en des points voulus de manière à avoir une inductance constante distribuée.

7. Système d'antenne à accord électronique selon la revendication 6, dépendante de la revendication 2, caractérisé en ce que les deux éléments d'antenne (8, 8¹) sont de forme régulière et repliés symétriquement et sont connectés ensemble par une partie conductrice (35) à leurs extrémités opposées aux extrémités des bornes d'attaque (9, 9¹).

8. Système d'antenne à accord électronique selon la revendication 6, caractérisé en ce que l'élément ou chaque élément d'antenne comporte des parties en zigzag (27c) pour augmenter la valeur de l'inductance constante distribuée.

9. Système d'antenne à accord électronique selon la revendication 6, caractérisé en ce que les parties repliées de l'élément ou chaque élément d'antenne (25) ont un écartement diminuant progressivement entre les parties voisines, avec une distance qui augmente à partir de l'extrémité des bornes d'attaque (26).

10. Système d'antenne à accord électronique selon la revendication 6, caractérisé en ce que les parties repliées de l'élément ou chaque élément d'antenne (25) ont une largeur perpendiculaire à l'axe longitudinal de l'élément d'antenne qui augmente progressivement avec l'augmentation de la distance à partir de l'extrémité des bornes d'attaque (26).

11. Système d'antenne à accord électronique selon l'une quelconque des revendications 6 à 10, caractérisé en ce que l'élément ou chaque élément d'antenne (28) est formé en une configuration plane qui est repliée le long d'au moins une ligne (170) parallèle ou le long de l'axe longitudinal de l'élément d'antenne.

12. Système d'antenne à accord électronique selon l'une quelconque des revendications 6 à 10, caractérisé en ce que l'élément ou chaque élément d'antenne (28) est formé dans une configuration plane qui est incurvée autour de l'axe longitudinal de l'élément d'antenne pour obtenir une forme au moins partiellement cylindrique.

13. Système d'antenne à accord électronique selon l'une quelconque des revendications précédentes, caractérisé en ce que l'élément ou chaque élément d'antenne (103), une inductance (105) du circuit à réactance variable, des points de connexion pour d'autres composants et des connexions entre eux sont prévus comme des conducteurs imprimés sur une base de circuits imprimés (102).

14. Système d'antenne à accord électronique selon l'une quelconque des revendications précédentes, caractérisé en ce que le circuit ou chaque circuit à réactance variable comporte en outre un circuit de changement de bande (135) comprenant plusieurs éléments à réactance commutables sélectivement (128—131), ledit circuit de changement de bande réagissant à un signal de changement de bande provenant dudit appareil de télécommunication pour commuter sélectivement un élément à réactance requis, assurant ainsi que ledit système d'antenne et ledit appareil de télécommunication coïncident dans leur fréquence d'accord sur plusieurs bandes de fréquence.

15. Système d'antenne à accord électronique selon la revendication 2, ou l'une quelconque des revendications 3 à 14 dépendant de la revendication 2, caractérisé en ce que ledit système d'antenne comporte une première et une seconde antennes dipôles (158, 159) disposées avec un intervalle prédéterminé entre elles, un dispositif de composition de signaux (161) étant connecté par des circuits d'attaque respectifs (156, 157) auxdites antennes, ledit dispositif qui applique une tension de polarisation contrôlée réagissant audit signal de commande en appliquant une tension de polarisation aux diodes à capacité variable associées avec ladite première et ladite seconde antennes.

16. Système d'antenne à accord électronique selon la revendication 15, caractérisé en ce qu'un convertisseur de phase (162) est prévu entre ladite seconde antenne dipôle (159) et ledit dispositif de composition de signaux (161), ladite première et ladite seconde antennes dipôles étant disposées de manière à être mutuellement en phase.

17. Système d'antenne à accord électronique selon la revendication 2, ou l'une quelconque des revendications 3 à 14 dépendantes de la revendication 2, caractérisé en ce que ledit système d'antenne comporte une antenne dipôle (165) comme élément rayonnant et au moins une autre antenne dipôle fonctionnant comme un élément directeur (164) et/ou un élément réflecteur (166), lesdites antennes étant espacées d'un quart de longueur d'onde en utilisation, des circuits à réactance variable étant associés avec chacune desdites antennes, lesdites tensions de polarisation contrôlée étant appliquées à chacune desdites antennes, ladite antenne dipôle formant élément rayonnant (165) comportant une borne d'attaque (167) pour des signaux électriques à une fréquence accordée par ledit système d'antenne.

18. Système d'antenne à accord électronique selon l'une quelconque des revendications précédentes, caractérisé en ce qu'un amplificateur sélectif en fréquence (44) est connecté au circuit ou à chaque circuit à réactance variable (37a, 37b) pour amplifier les signaux électriques associés avec la conversion de rayonnement électromagnétique, et la tension de polarisation contrôlée pour les diodes à capacité variable (38a, 38b) étant appliquée en outre à l'amplificateur (44) de manière à permettre un accord coopérant du système d'antenne et de l'amplificateur (44).

FIG. 1.

FIG. 2.

FIG. 3.

FIG.4.

FIG.5.

300Ω NORMALIZED

FIG. 6.

FIG. 7.

FIG. 8.

FIG. 9.

30

30'

29

29'

FIG.10.

32

32'

31

31'

FIG.11.

34

34'

33

33'

FIG.12.

35

8'

9

9'

8'

*36*

*Fig. 13.*

*8*        *9*  *9'*        *8'*

*37*

*8'*

*Fig. 14.*

*8*

*9'*

*9*

*10-1*  *11*  *10-2*        *10-2'*  *11'*  *10-1'*

*12*  *14*  *12'*  *Fig. 15.*

*13*  *13'*

*15-1*  *16*  *15-2*        *15-2'*  *16'*  *15-1'*

*18*

*23*

*24*  *17*  *21*  *22*  *22'*  *21'*  *18'*  *17'*  *24'*

BIAS
VOLTAGE

BIAS
VOLTAGE

*Fig. 16.*

27a (27a')  27c (27c')  25(25')  27a(27a')  27a (27a')  27c (27c')  27b (27b')  27b (27b')  27a(27a')  27b (27b')  27a(27a')  27b (27b')  27a(27a')

**FIG. 17.**

27a(27a')  27c(27c')  25(25')  27a(27a')  27c(27c')  27a (27a')

**FIG. 18.**

27c (27c')  27a (27a')  27c (27c')  27c(27c')  27a (27a')  25(25')

**FIG. 19.**

25(25¹)

26 (26¹)   FIG. 20.

25   25¹

26   26¹

FIG. 21.

28 (28¹)   170   28(28¹)

a   b

FIG. 22.

FIG. 23.

FIG. 24.

FIG. 25.

FIG. 26.

FIG. 27.

FIG. 28.

Fig.29.

FIG. 30.

FIG. 31.

103 102 103'

107 104 104' 107'

105

106 105'

108 106'

109 109'

110 108' 110'

111

FIG.32.

116

113 112 117 115 118 117 113'

114 114'

120 119

FIG.33.

0 021 762

FIG.34.

FIG.35.

13

FIG.36.

FIG. 37.

FIG.38(a)

FIG.38(b)

FIG. 39.

FIG. 40.

$\lambda/4$  $\lambda/4$

DIRECTOR *164*

*165*  *166*  REFLECTOR

F

*167*

*163*

B

RADIATOR

FIG.41.

FIG.42.

FIG.43.

RADIATOR — 165    166 — REFLECTOR

λ/4

F ⇐    ⇒ B

167

163

FIG. 44.

DIRECTOR — 164    165 — RADIATOR

λ/4

F ⇐    167    ⇒ B

163

FIG. 45.